# EUROPEAN PATENT SPECIFICATION

(11) **EP 0 458 325 B1**
(45) Date of publication and mention of the grant of the patent: **19.08.1998**
(21) Application number: 91108335.0
(22) Date of filing: 23.05.1991
(51) Int. Cl.: G03F 7/004

(54) **Negative photosensitive composition and method for forming a resist pattern**
Negative lichtempfindliche Zusammensetzung und Verfahren zur Bildung eines Photolackmusters
Composition photosensible négative et procédé pour réaliser une structure de réserve

(30) Priority: 25.05.1990 JP 136843/90; 14.06.1990 JP 155649/90; 15.06.1990 JP 157146/90; 12.06.1990 JP 184648/90; 31.08.1990 JP 231453/90; 19.09.1990 JP 249255/90; 28.09.1990 JP 260156/90; 20.12.1990 JP 404434/90
(43) Date of publication of application: 27.11.1991
(73) Proprietor: Mitsubishi Chemical Corporation, Chiyoda-ku Tokyo (JP)
(72) Inventor: Ochiai, Tameichi, Sagamihara-shi, Kanagawa-ken (JP); Takahashi, Noriaki, Yokohama-shi, Kanagawa-ken (JP); Ishiguro, Tomoyo, Yokohama-shi, Kanagawa-ken (JP); Yoshizawa, Mika, Machida-shi, Tokyo (JP)
(74) Representative: Wächtershäuser, Günter, Prof. Dr.

(56) References cited:
- EP-A- 232 972
- EP-A- 369 379
- EP-A- 382 209
- EP-A- 401 499
- EP-A- 419 147
- FR-A- 2 389 157
- GB-A- 2 039 073
- PATENT ABSTRACTS OF JAPAN vol. 14, no. 78 (P-1006)(4021) 14 February 1990, & JP-A-01 293339 (TOSOH CORP) 27 November 1989
- Polymers in Microlithography, Materials and Process, ACS Symposium Series 412, 9-14 april 1989, Chapter 6, pages 87-99

## Description

The present invention generally relates to a negative photosensitive composition sensitive to radiation. More particularly, it relates to a negative photoresist suitable for production of semiconductor integrated circuits and a method for forming a resist pattern.

As generally reported, high integration of semiconductor integrated circuits progresses at a rate of four times in three years. For example, in a case of dynamic random access memory (DRAM), a device having a memory capacity of 4 megabit is commercially available by now. Accordingly, the requirements in the photolithography technique indispensable to the production of integrated circuits have become strict year by year. For example, for the production of 4 megabit DRAM, a lithography technique at a level of 0.8 µm is required, and it is expected that for a more highly integrated circuit at a level of 16 megabit or 64 megabit DRAM, lithography at a level of 0.5 µm or 0.3 µm will be required, respectively. Accordingly, it is desired to develop a resist capable of being used for lithography of a half micron level.

A negative resist in which cyclized rubber and a bisazide compound as a crosslinking agent are used, is well known as a resist useful for photolithography. However, with such a negative resist, swelling takes place during development by the action of an organic solvent used for the development, and the image resolving power is 3 µm at best. Therefore, such a negative resist is not suitable for the production of a highly integrated device. Further, the organic solvent used for the development is problematic from the aspects of environment and health or in view of inflammability.

Further, a positive resist comprising naphthoquinone diazide and an alkali-soluble novolak resin is well known. However, such a positive resist exhibits a substantial absorption at 300 nm or less and thus has a drawback that when exposure is conducted at a short wavelength, the pattern profile will be very poor. Therefore, exposure has to be conducted at a wavelength of at least about 350 nm, whereby the resolving power is limited and it is not useful for lithography of a half micron level.

On the other hand, as a candidate useful for high resolving power lithography, X-ray lithography or electron beam lithography may be mentioned. However, the former is still behind in the development of the hardware and resist, and the latter is not suitable for mass production from the viewpoint of through-put.

Accordingly, it is strongly desired to develop a resist having a good pattern profile, which is useful for exposure in a deep UV region using a low pressure mercury lamp or excimer laser as the light source and which is useful for lithography of a half micron level, in order to obtain a high resolving power.

As a resist useful for exposure with a light in the deep UV region, Japanese Unexamined Patent Publication No. 164045/1987 discloses a negative photoresist composition comprising an acid curable resin and a halogenated organic compound as a photo-acid-generating material. As the halogenated organic compound, tri(2,3-dibromopropyl)isocyanurate, 1,10-dibromodecane, 1,2,3,4,5,6-hexachlorocyclohexane and hexachlorodimethylsulfone are disclosed as examples. However, with such a photo-acid-generating material, the sensitivity or the resolution is not adequate, and it is not possible to obtain a good pattern profile.

It is an object of the present invention to solve the above problems of the prior art and to provide a photosensitive composition which is useful for exposure with a light in the UV region and which has high sensitivity and is capable of providing a good pattern profile suitable for lithography of a half micron level.

Another object of the present invention is to provide a method for forming a fine resist pattern having a good cross-sectional shape.

The present invention provides a negative photosensitive composition comprising an alkali-soluble resin, a photo-acid-generating material and a crosslinking agent for the alkali-soluble resin, which acts under an acidic condition, wherein said photo-acid-generating material is at least one member selected from the group consisting of a C₁-C₈ paraffin hydrocarbon or C₅-C₇ cycloparaffin hydrocarbon substituted by at least two bromine or iodine atoms.

The present invention also provides a method for forming a resist pattern on a semiconductor substrate, which comprises coating the above negative photosensitive composition of the present invention on the substrate, heating and drying it, then subjecting it to exposure by a mercury lamp or excimer laser, further subjecting it to heat treatment, followed by development with an alkaline aqueous solution to form a resist pattern on the substrate.

Now, the present invention will be described in detail with reference to the preferred embodiments.

The main feature of the present invention resides in the use of the above specific photo-acid-generating material in the negative photosensitive composition comprising an alkali-soluble resin, a photo-acid-generating material and a crosslinking agent for the alkali-soluble resin, which acts under an acidic condition.

One type of the photo-acid-generating material useful in the present invention is a C₁-C₈ paraffin hydrocarbon or C₅-C₇ cycloparaffin hydrocarbon substituted by at least two bromine or iodine atoms.

The C₁-C₈ paraffin hydrocarbon substituted by bromine or iodine atoms, may be straight chain or branched chain alkyl such as methyl, ethyl, n-propyl, i-propyl, n-butyl, t-butyl, n-pentyl, n-hexyl or n-octyl. The C₅-C₇ cycloparaffin hydrocarbon substituted by bromine or iodine atoms, may be cycloalkyl such as cyclopentyl, cyclohexyl or cycloheptyl. Among them, a C₁-C₆ paraffin hydrocarbon or C₅-C₇ cycloparaffin hydrocarbon is preferred, and a C₁-C₄ paraffin hydrocarbon or cyclohexane is more preferred.

Such a paraffin hydrocarbon or cycloparaffin hydrocarbon is substituted by at least two bromine or iodine atoms. There is no particular restriction as to the number of such substituents, and all hydrogen atoms of the hydrocarbon may be substituted by bromine or iodine atoms. Further, there is no particular restriction as to the positions for substitution by bromine or iodine atoms.

Specific examples of the above photo-acid-generating material include carbon tetrabromide, bromoform, iodoform, 1,1,1-tribromoethane, 1,1,2-tribromoethane, 1,1,1,2-tetrabromoethane, 1,1,2,2-tetrabromoethane, 1,2-dibromobutane, 1,4-dibromobutane, 1,2,3-tribromobutane, 1,2,3,4-tetrabromobutane, 1,1,2,3-tetrabromobutane, 1,2,3-tribromohexane, 1,2,3,4,5,6-hexabromohexane, 1,2-dibromocyclohexane, 1,2,3-tribromocyclohexane and 1,2,3,4,5,6-hexabromocyclohexane.

The photo-acid-generating material of the present invention may be used in a liquid form or in a solid form, but is required not to evaporate or sublimate during the drying step after coating of the photoresist composition on a substrate. Accordingly, it is preferably the one having a boiling point of at least 180°C, more preferably at least 220°C.

The photo-acid-generating material of the present invention is preferably substituted by bromine. Among photo-acid-generating materials of the present invention, it is particularly preferred to employ tetrabromomethane, iodoform, 1,2,3,4-tetrabromobutane, 1,1,2,2-tetrabromoethane, 1,2,3,4,5,6-hexabromocyclohexane.

The alkali-soluble resin to be used in the present invention is not particularly limited. However, the one having a phenolic hydroxyl group is preferred.
Particularly preferred is the one having a transmittance of at least 20% with a layer thickness of 1 µm at the exposure wavelength within a range of from 150 to 300 nm. Such a resin may, for example, be a novolak resin obtained by polycondensing a hydroxyl aromatic compound such as phenol, cresol, ethylphenol, t-butylphenol, xylenol, naphthol, 1,4-dihydroxybenzene or 1,3-dihydroxybenzene, with an aldehyde such as formaldehyde, acetaldehyde, benzaldehyde or furfural, a polymer of a vinylphenol derivative optionally having lower alkyl such as methyl or ethyl substituted on the benzene ring or on the vinyl group, i.e. a polyvinylphenol derivative which may have a substituent such as lower alkyl, or a N-(p-hydroxyphenyl)maleimide polymer. Among them, a polyvinylphenol derivative which may be substituted by lower alkyl, is preferred.

The weight average molecular weight of the alkali-soluble resin of the present invention is usually at a level of from 100 to 20,000.

The crosslinking agent useful for the present invention is not particularly limited so long as it is a compound capable of performing a crosslinking reaction with the alkali-soluble resin in the presence of an acid. For example, it includes compounds referred to in Japanese Unexamined Patent Publications No. 113435/1984, No. 263143/1985 and No. 164045/1987 and compounds disclosed in Phenolic Resins edited by A. Knop, L.A. Pilato.

Specifically, it may be a compound having at least two groups of the following formula (V) per molecule, or a compound having at least one group of the following formula (VI) per molecule:

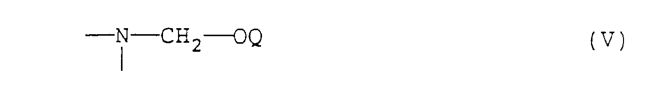

-N(CH₂OQ')₂ (VI)

wherein each of Q and Q', which are independent from each other, is hydrogen or C₁-C₄ alkyl.

Among them, a monomer is preferred rather than an amino resin such as a melamine resin or a urea resin. More specifically, compounds of the following formulas (VII) to (XII) may be mentioned as the crosslinking agent:

Q¹OCH₂NHCONHCH₂OQ² (VII)

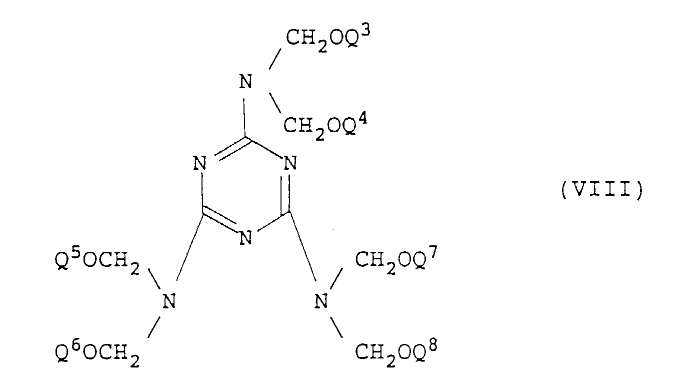

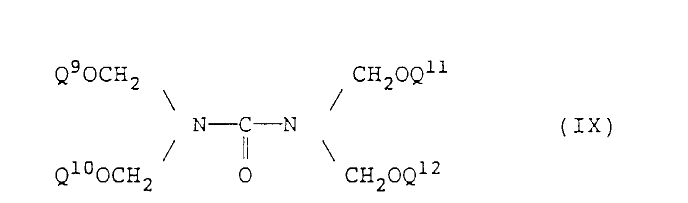

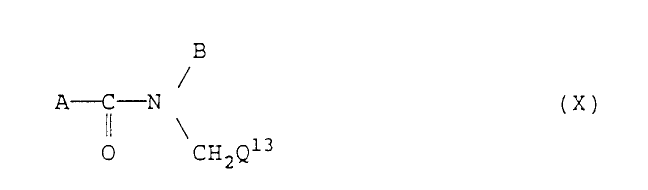

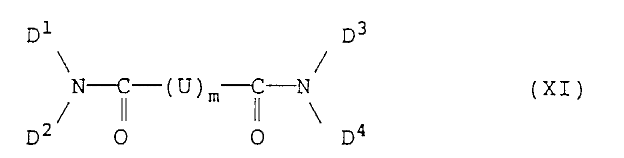

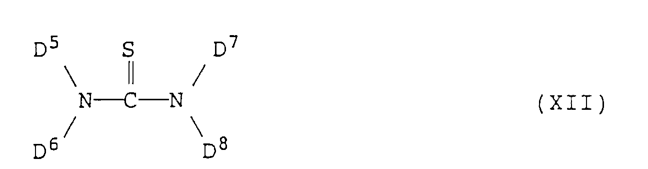

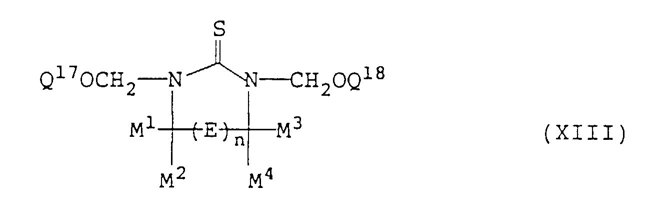

In the above formulas (VII) to (XIII), each of Q¹ to Q¹³, Q¹⁷ and Q¹⁸, which are independent from one another, is hydrogen or lower alkyl. A is alkyl, alkenyl, aryl or a 5- or 6-membered aromatic heterocyclic group, which may be substituted, and B is hydrogen or -CH₂OQ¹⁴, wherein Q¹⁴ is lower alkyl. U is a bivalent organic group, and each of D¹ to D⁴, which are independent from one another, is hydrogen or -CH₂OQ¹⁵, wherein Q¹⁵ is lower alkyl, and m is 0 or 1, provided that at least two of D¹ to D⁴ are not hydrogen. Each of D⁵ to D⁸, which are independent from one another, is hydrogen or -CH₂OQ¹⁶, wherein Q¹⁶ is hydrogen or lower alkyl, provided that at least two of D⁵ to D⁸ are not hydrogen. Each of M¹, M², M³ and M⁴, which are independent from one another, is hydrogen, lower alkyl, hydroxyl or lower alkoxy. E is alkylene, oxygen or 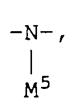 wherein M⁵ is hydrogen or alkyl, and n is 0 or 1.

The lower alkyl for Q³ to Q¹⁸ and M¹ to M⁴ may be C₁-C₄ lower alkyl such as methyl, ethyl, n-propyl, i-propyl or n-butyl. Q¹ to Q¹⁸ in the above formulas (VII) to (XIII) are preferably hydrogen or C₁-C₂ alkyl. The lower alkoxy for M¹ to M⁴ may be C₁-C₄ alkoxy such as methoxy, ethoxy, n-propoxy, i-propoxy or n-butoxy.

The alkyl for A in the above formula (X) may be a C₁-C₆ alkyl such as methyl, ethyl, n-propyl, i-propyl, n-butyl, t-butyl, n-pentyl or n-hexyl. The alkenyl may be C₂-C₆ alkenyl such as vinyl, l-propenyl, allyl, crotyl or 2-pentenyl. The aryl may be phenyl or naphthyl. The 5-or 6-membered aromatic heterocyclic group may be pyridyl. Further, these groups may be substituted by nitro, cyano, halogen, C₁-C₄ lower alkyl, C₁-C₄ lower alkoxy or phenyl. In the formula (X), A is preferably C₁-C₄ alkyl, C₃-C₄ alkenyl or aryl, and B is preferably -CH₂OQ¹⁴. More preferably, A is phenyl and B is -CH₂OQ¹⁴.

In the formula (XI), the bivalent organic group for U may be C₁-C₆ alkylene such as methylene, ethylene, trimethylene, tetramethylene, pentamethylene or hexamethylene, arylene such as phenylene or naphthylene, a 5- or 6-membered aromatic heterocyclic bivalent residue, or a group having methylene and phenylene bonded to each other, such as 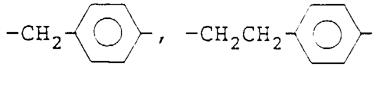 or 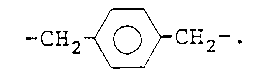 Further, these groups may be substituted by nitro, cyano, halogen, C₁-C₄ lower alkyl, C₁-C₄ lower alkoxy or phenyl. In the formula (XI), preferred is the one wherein U is C₁-C₄ alkylene, m is 1, and each of D¹ to D⁴ is -CH₂OQ¹⁵. Here, a plurality of -CH₂OQ¹⁵ may be the same or different.

In the formula (XIII), preferred is the one wherein each of Q¹⁷ and Q¹⁸, which are independent from each other, is hydrogen or C₁-C₂ alkyl, n is 0 or 1, and E is methylene or 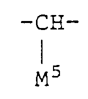 wherein M⁵ is C₁-C₄ alkyl.

The compound of the above formula (VII) includes dimethylolurea, N,N'-dimethoxymethylurea, N,N'-diethoxymethylurea and N,N'-dipropoxymethylurea.

The compound of the above formula (VIII) includes hexamethoxymethylmelamine, hexaethoxymethylmelamine, hexapropoxymethylmelamine and hexabutoxymethylmelamine.

The compound of the above formula (IX) includes tetramethylolurea, tetramethoxymethylurea, tetraethoxymethylurea and tetrabutoxymethylurea.

The compound of the above formula (X) includes N,N-dimethoxymethylacetamide, N,N-dimethoxymethylpropionamide, N,N-dimethoxymethylacrylamide and N,N-dimethoxymethylbenzamide.

The compound of the above formula (XI) includes tetramethoxymethyloxamide, N,N'-dimethoxymethylmalonamide, N,N,N',N'-tetramethoxymethylmalonamide, N,N'-dimethoxymethylsuccinamide, N,N,N',N'-tetramethoxymethylsuccinamide, N,N'-dimethoxymethyladipinamide, N,N,N',N'-tetramethoxymethyladipinamide, N,N,N',N'-tetramethoxymethylphthalamide, a hexamethoxymethyl ester of trimellitic acid triamide and an octamethoxymethyl ester of pyromellitic acid tetramide.

The compound of the above formula (XII) includes N,N'-dimethoxymethylthiourea and N,N,N',N'-tetramethoxymethylthiourea.

The compound of the above formula (XIII) includes N,N'-dimethoxymethylethylene thiourea, N,N'-dimethoxymethylpropylene thiourea, N,N'-dibutoxymethylethylene thiourea, 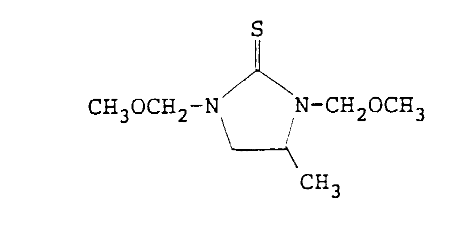 and

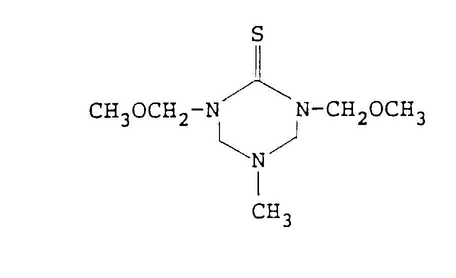

Among the above crosslinking agent, it is particularly preferred to employ N,N'-dimethylolurea, N,N,N',N'-tetramethoxymethylurea, hexamethoxymethylmelamine, N,N,N',N'-tetramethoxymethylmalonamide, N,N'-dimethoxymethylsuccinamide, N,N,N',N'-tetramethoxymethylsuccinamide, N,N'-dimethoxymethyladipinamide and N,N'-dimethoxymethylethylene thiourea.

In the present invention, the above crosslinking agents may be used alone or in combination as a mixture. Further, when compounds of the formulas (VII) to (XIII) are used as crosslinking agents, other crosslinking agents may be incorporated thereto. Such other crosslinking agents may, for example, be substances of the following formula (XIV), or polymers formed by the reaction of a plurality of molecules of the substance of the above formula (IX). 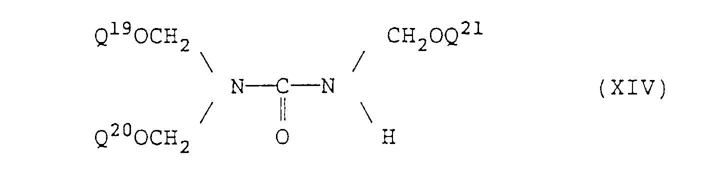 wherein each of Q¹⁹, Q²⁰ and Q²¹, which are independent from one another, is hydrogen or C₁-C₄ alkyl.

When the crosslinking agent contains a crosslinking agent other than the substance of the above formulas (VII) to (XIII), the substance of the above formulas (VII) to (XIII) is preferably present in an amount of at least 50% by weight in the crosslinking agent.

The blending ratio of the alkali-soluble resin, the photo-acid-generating material and the crosslinking agent in the negative photosensitive composition of the present invention is such that the photo-acid-generating material is in an amount of from 0.05 to 20 parts by weight, preferably from 0.1 to 10 parts by weight, per 100 parts by weight of the alkali-soluble resin, and the crosslinking agent is in an amount of from 1 to 50 parts by weight, preferably from 5 to 30 parts by weight, per 100 parts by weight of the alkali-soluble resin.

The negative photosensitive composition of the present invention may contain various additives, such as a dye, a coating property-improving agent, a spectral sensitizer and a development-improving agent, to such an extent not to impair the properties.

The composition of the present invention is used usually as dissolved in a solvent. The solvent is not particularly limited, so long as it is a solvent capable of presenting adequate solubility to the resin and the photosensitive agent and capable of providing good coating property. For example, it may be a cellosolve type solvent such as methyl cellosolve, ethyl cellosolve, methyl cellosolve acetate or ethyl cellosolve acetate, a propylene glycol type solvent such as propylene glycol monoethyl ether, propylene glycol monobutyl ether, propylene glycol monomethyl ether acetate, dipropylene glycol dimethyl ether or propylene glycol monoethyl ether acetate, an ester type solvent such as butyl acetate, amyl acetate, ethyl butyrate, butyl butyrate, diethyl oxalate, ethyl pyruvate, ethyl-2-hydroxybutylate, 2-methyl-acetoacetate, methyl lactate or ethyl lactate, an alcohol type solvent such as heptanol, hexanol, diacetone alcohol or furfuryl alcohol, a ketone type solvent such as cyclohexanone or methylamyl ketone, or an ether type solvent such as methyl phenyl ether or diethylene glycol dimethyl ether, a high polar solvent such as dimethylformamide or N-methylpyrrolidone, or a solvent mixture thereof, or a solvent mixture having an aromatic hydrocarbon added thereto.

The solvent is used preferably in an amount of from 1 to 20 times by weight relative to the total amount of the solid content of the negative photosensitive composition.

The negative photosensitive composition of the present invention is useful as a photosensitive composition for the production of not only very large scale integrated circuits but also for the production of usual semiconductors such as large scale integrated circuits or usual integrated circuits, for the production of masks, for the production of printed circuits, or for offset printing, as well as other uses such as a solder resist, image-forming material or a ultraviolet curable coating material. It is particularly useful as a photoresist for the production of semiconductors.

To form a resist pattern on a semiconductor substrate by means of the photoresist of the present invention, the photoresist of the present invention dissolved in the above-mentioned solvent is usually coated on the semiconductor substrate, heat-dried, then subjected to exposure by a mercury lamp or an excimer laser, further subjected to heat treatment, followed by development with an alkaline aqueous solution.

The semiconductor substrate may be the one commonly employed as a substrate for the production of semiconductors, such as a silicon substrate or a gallium-arsenic substrate.

Coating of the photoresist on the substrate is usually conducted by a spin coater, and the thickness of the coated layer is usually from 0.5 to 2 µm.

The heat drying treatment after coating the photoresist on the substrate may be conducted under any conditions so long as the solvent of the photoresist can thereby be removed, and it is usually conducted at a temperature of from 70 to 150°C for from 1 to 60 minutes.

For the exposure, a light of 254 nm from a light source of a low pressure mercury lamp, or a light of 157 nm, 193 nm, 222 nm or 249 nm from a light source of e.g. an excimer laser, is suitably employed. Further, a light of 366 nm or 436 nm from a high pressure mercury lamp is also effective. The light for the exposure may not necessarily be a monochromatic light and may be broad. Further, the photoresist of the present invention is useful also as a resist for a phase shift method. It is particularly effective to employ a light of 254 nm or 249 nm generated by a low pressure mercury lamp or an excimer laser as the light source, since lithography of a half micron level is thereby possible.

The heating after exposure (Post Exposure Bake) is preferably conducted under conditions of from 90°C to 140°C for 1 to 10 minutes by means of a hot plate. Instead of the hot plate, a convection oven may be employed. In this case, however, a longer time is usually required than the case where a hot plate is employed.

The alkaline aqueous solution to be used for the development of a resist pattern, may be an aqueous solution of an inorganic alkali such as potassium hydroxide, sodium carbonate, sodium silicate, sodium metasilicate or aqueous ammonia, a primary amine such as ethylamine or n-propylamine, a secondary amine such as diethylamine or di-n-propylamine, a tertiary amine such as triethylamine or trimethylamine or a quaternary ammonium salt such as tetramethylammonium hydroxide or trimethylhydroxyethylammonium hydroxide. To the developing solution, an alcohol, a surfactant, etc. may be incorporated as the case requires.

The developing time is usually from 30 to 90 seconds, and the developing temperature is usually from 10 to 30°C.

The photoresist solution and the developing solution are usually filtered to remove insolubles before use.

Now, the present invention will be described in further detail with reference to Examples. However, it should be understood that the present invention is by no means restricted by such specific Examples.

### EXAMPLES 1 to 5

2 g of polyvinylphenol having a weight average molecular weight of 5100, 0.4 g of hexamethoxymethylmelamine and a photo-acid-generating material as identified in Table 1 in an amount as identified in Table 1, were dissolved in 7 g of ethyl lactate, and the solution was filtered through a teflon filter paper of 0.2 µm to obtain a photoresist composition.

This photoresist composition was coated in a thickness of 1.0 µm on a silicon wafer having a diameter of 4 inch by a spin coater (IH-2D, manufactured by Mikasa) and dried at 100°C for 70 seconds on a hot plate. The coated wafer was placed at about 20 cm below a 6 W low pressure mercury lamp (manufactured by Ushio Denki K.K.) and subjected to exposure with a light energy of 0.4 mW/cm² by varying the exposure time from 0 second to 10 minutes. Then, the wafer was heated at 110°C for 90 seconds on a hot plate (Post Exposure Bake) and developed at 25°C for 10 minutes with a 1.23% tetramethylammonium hydroxide aqueous solution, whereby the dissolving speed of the resist was obtained, and the sensitivity (best exposure energy) was obtained.

On the other hand, a photomask (manufactured by Toppan Insatsu K.K.) was placed on the silicon wafer having the photoresist composition coated thereon and dried, and exposure was conducted in the same manner as above by means of a low pressure mercury lamp at the best exposure energy for from 10 to 30 seconds. Then, the post exposure bake was conducted in the same manner as above, and the development was conducted in the same manner at 25°C for 50 seconds to form a resist pattern, whereupon the resolution was observed by a scanning electron microscope. The results are shown in Table 1, from which it is evident that the dissolving speed of the non-exposed portion (indicating the developing property) was sufficiently high, and the sensitivity (best exposure energy) was good. The resolution was also good, and a line and space of 0.5 µm was resolved.

### COMPARATIVE EXAMPLES 1 to 4

The resist solution was prepared in the same manner as in Example 1 except that instead of the photo-acid-generating material in Example 1, a compound as identified in Table 1 was used, and the evaluation was conducted in the same manner. The results are shown in Table 1, from which it is evident that in Comparative Examples 1 to 3, the sensitivity was very poor, and in Comparative Examples 4 and 5, the dissolving speed of the non-exposed portion was very low, and even the non-exposed portion could not be developed, and in each case, no image was formed.

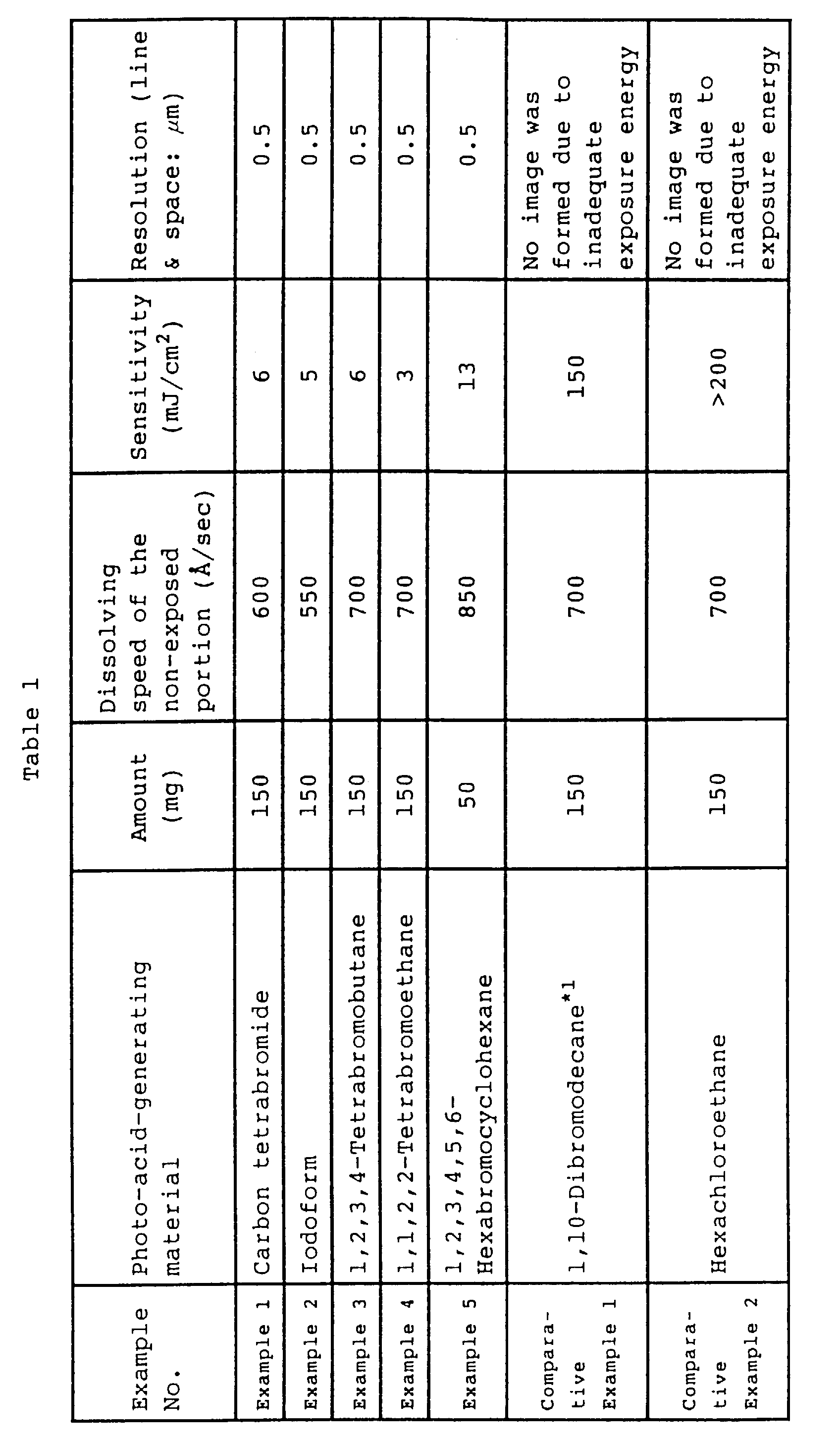

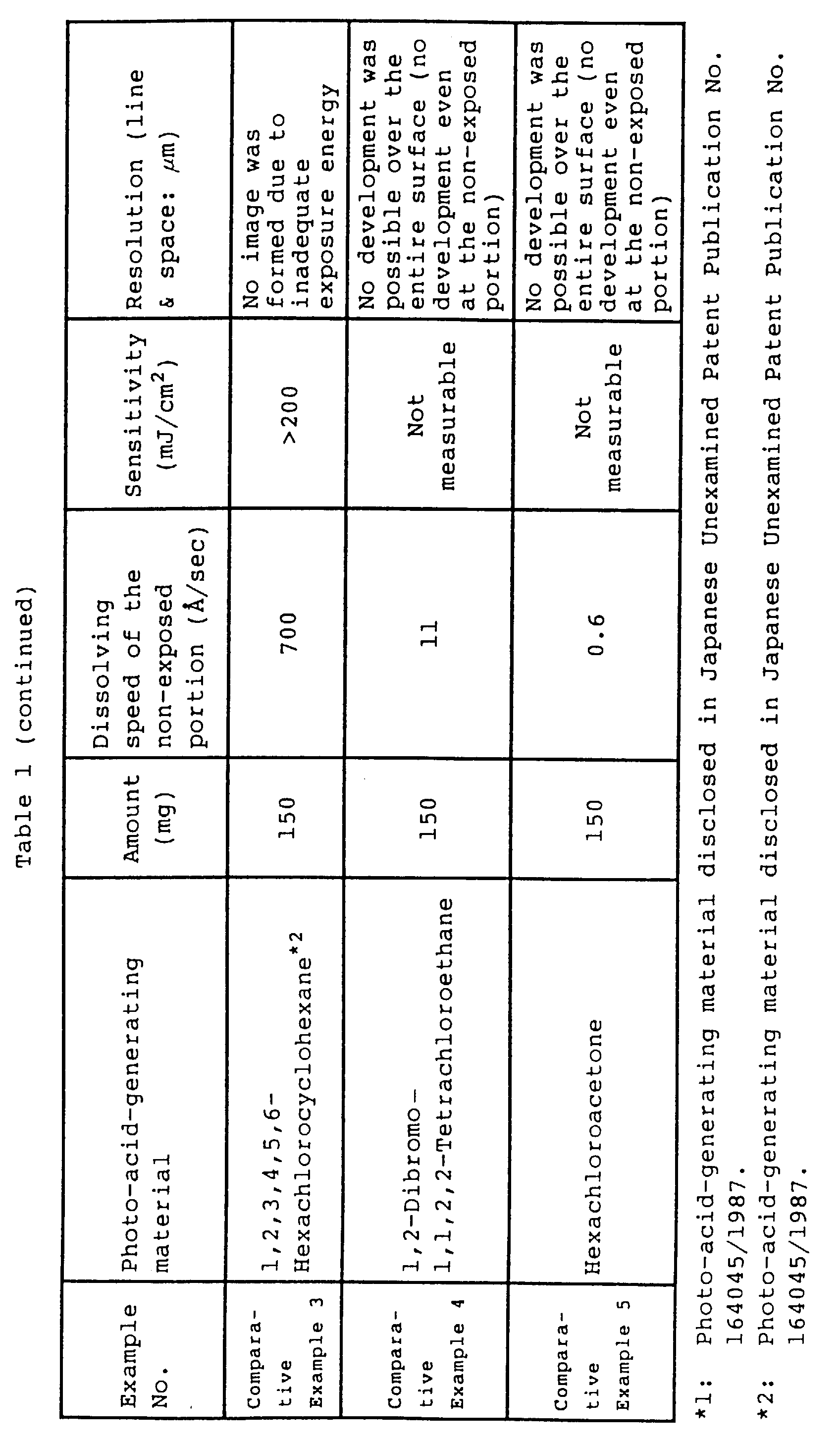

### EXAMPLE 6

20 g of a polyvinylphenol having a weight average molecular weight of 5100, 4 g of N,N'-dimethoxymethylethylene thiourea as a crosslinking agent and 1 g of 1,2,3,4-tetrabromobutane as a photo-acid-generating material, were dissolved in 70 g of ethyl lactate, and the solution was filtered through a teflon filter paper of 0.2 µm to obtain a photoresist composition. This photoresist composition was coated in a thickness of 1.0 µm on a silicon wafer having a diameter of 4 inch by a spin coater (1H-2D, manufactured by Mikasa), and dried at 100°C for 70 seconds on a hot plate. The coated wafer was subjected to exposure by means of an excimer laser reduction-type projection printing by varying the exposure energy and then the post exposure bake was conducted at 110°C for 90 seconds on a hot plate. Then, development was conducted for 70 seconds with a 1.23% tetramethylammonium hydroxide solution to form a negative image. The resist pattern thereby obtained was observed by a scanning electron microscope (manufactured by Akashi Seisakusho K.K.), whereby a line and space of 0.35 µm was found to be resolved. The sensitivity was good, the dissolving speed of the non-exposed portion was sufficiently high, the developing property was good, and the storage stability was also good.

### EXAMPLE 7

A photoresist composition was prepared and evaluated in the same manner as in Example 6 except that the crosslinking agent was changed to 3 g of N,N'-dimethoxymethyl thiourea and the photo-acid-generating material was changed to 0.5 g of 1,2,3,4-tetrabromobutane, whereby a line and space of 0.35 µm was found to be resolved. The sensitivity was good, the dissolving speed of the non-exposed portion was sufficiently high, the developing property was good, and the storage stability was also good.

### EXAMPLES 8 and 9 and COMPARATIVE EXAMPLES 6-10

20 g of a polyvinylphenol having a weight average molecular weight of 5100, 4 g of hexamethoxyemthylmelamine as a crosslinking agent and a compound as identified in Table 4 as a photo-acid-generating material in an amount as identified in Table 4 were dissolved in 70 g of propylene glycol monoethyl ether acetate, and the solution was filtered through a teflon filter paper of 0.2 µm to obtain a photoresist composition. Using this photoresist composition, a resist pattern was formed and the evaluation was conducted in the same manner as in Example 21 except that the developing time was changed to 70 seconds. The results are shown in Table 4, from which it is evident that the photoresists of Examples 8 and 9 are excellent in the resolution, the best exposure energy was practically satisfactory, the sensitivity was good, the dissolving speed of the non-exposed portion was sufficiently high, and the developing property was good.

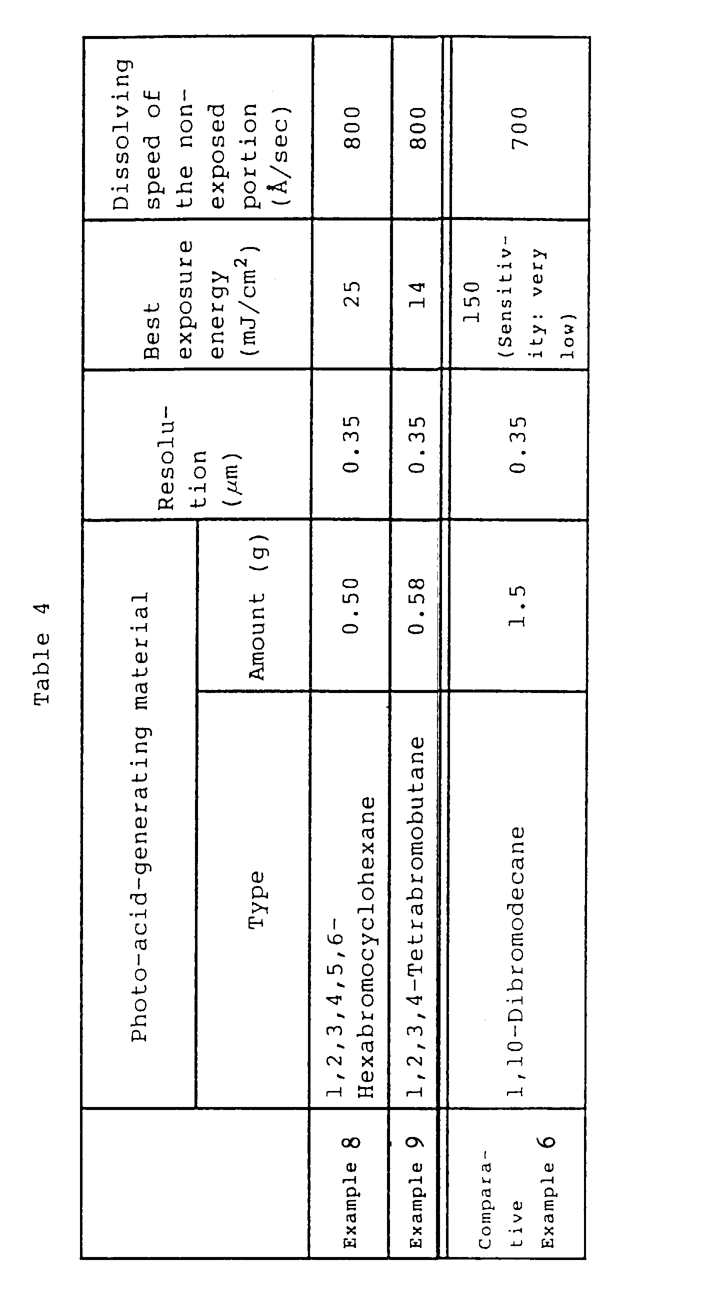

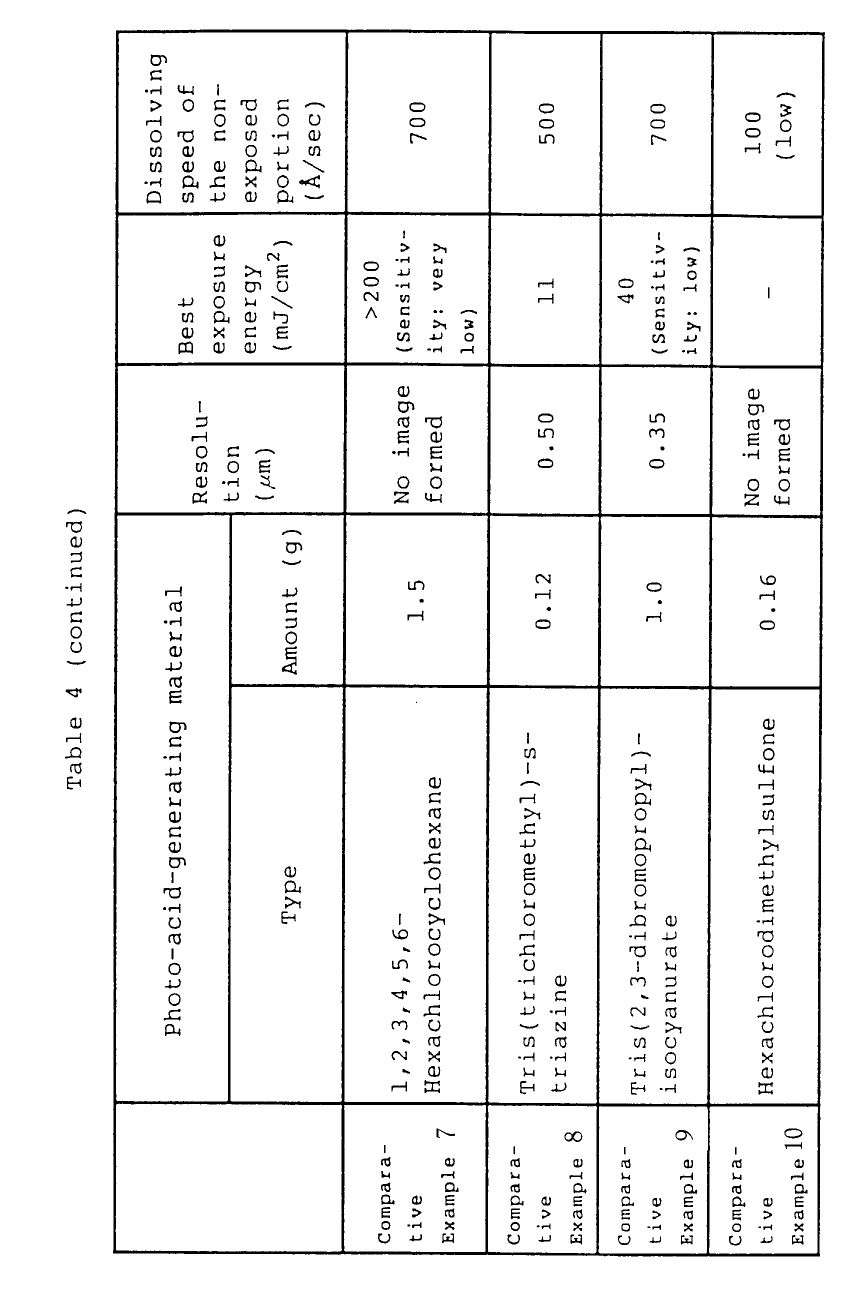

## Claims

1. A negative photosensitive composition comprising an alkali-soluble resin, a photo-acid-generating material and a crosslinking agent for the alkali-soluble resin, which acts under an acidic condition, wherein said photo-acid-generating material is at least one member selected from the group consisting of a C₁-C₈ paraffin hydrocarbon or C₅-C₇ cycloparaffin hydrocarbon substituted by at least two bromine or iodine atoms.

2. The negative photosensitive composition according to Claim 1, wherein the photo-acid-generating material is a C₁-C₆ paraffin hydrocarbon or C₅-C₇ cycloparaffin hydrocarbon, which is substituted by at least two bromine or iodine atoms.

3. The negative photosensitive composition according to Claim 1, wherein the alkali-soluble resin is a novolak resin or a polyvinyl phenol derivative.

4. The negative photosensitive composition according to Claim 1, wherein the crosslinking agent is a compound having at least two groups of the following formula (V) per molecule, or a compound having at least one group of the following formula (VI) per molecule: 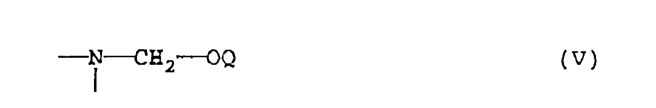
-N(CH₂OQ')₂ (VI)
wherein each of Q and Q', which are independent from each other, is hydrogen or C₁-C₄ alkyl.

5. The negative photosensitive composition according to Claim 1, wherein the photo-acid-generating material is in an amount of from 0.05 to 20 parts by weight and the crosslinking agent is in an amount of from 1 to 50 parts by weight, per 100 parts by weight of the alkali-soluble resin.

6. A.method for forming a resist pattern on a substrate for a semiconductor, which comprises the step of (1) coating on the substrate a negative photosensitive composition comprising an alkali-soluble resin, a crosslinking agent for the alkali-soluble resin, which acts under an acidic condition, and at least one photo-acid-generating material selected from the group consisting of a C₁-C₈ paraffin hydrocarbon or C₅-C₇ cycloparaffin hydrocarbon substituted by at least two bromine or iodine atoms, (2) heating and drying it, (3) subjecting it to exposure by means of a mercury lamp or excimer laser, (4) subjecting it to heat treatment and (5) developing it with an alkali aqueous solution to form a resist pattern on the substrate.

## Patentansprüche

1. Negative lichtempfindliche Zusammensetzung, umfassend ein alkalilösliches Harz, ein Säure-erzeugendes Photomaterial und ein Vernetzungsmittel für das alkalilösliche Harz, welches unter sauren Bedingungen wirkt, wobei das Säure-erzeugende Photomaterial mindestens ein Mitglied, ausgewählt aus der Gruppe, bestehend aus einem C₁-C₈-Paraffinkohlenwasserstoff oder C₅-C₇-Cycloparaffinkohlenwasserstoff, der mit mindestens zwei Brom- oder Iodatomen substituiert ist, ist.

2. Negative lichtempfindliche Zusammensetzung nach Anspruch 1, wobei das Säure-erzeugende Photomaterial ein C₁-C₆-Parafiinkohlenwasserstofi oder C₅-C₇-Cycloparaffinkohlenwasserstoff ist, das mit mindestens zwei Brom- oder Iodatomen substituiert sind.

3. Negative lichtempfindliche Zusammensetzung nach Anspruch 1, wobei das alkalilösliche Harz ein Novolak-Harz oder eine Polyvinylphenol-Derivat ist.

4. Negative lichtempfindliche Zusammensetzung nach Anspruch 1, wobei das Vernetzungsmittel eine Verbindung mit mindestens zwei Gruppen der folgenden Formel (V) pro Molekül oder eine Verbindung mit mindestens einer Gruppe der folgenden Formel (VI) pro Molekül ist: 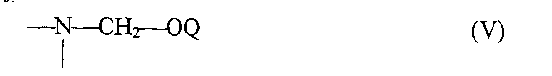
-N(CH₂OQ')₂ (VI)
wobei jedes Q und Q', die unabhängig voneinander sind, für Wasserstoff oder C₁-C₄-Alkyl steht,

5. Negative lichtempfindliche Zusammensetzung nach Anspruch 1, wobei das Säure-erzeugende Photomaterial in einer Menge von 0,05 bis 20 Gew.-Teilen vorliegt und das Vernetzungsmittel in einer Menge von 1 bis 50 Gew.-Teilen vorliegt, jeweils bezogen auf 100 Gew.-Teile des alkalilöslichen Harzes.

6. Verfahren zur Bildung eines Photolackmusters auf einem Substrat für einen Halbleiter, welches umfaßt den Schritt (1) einer Beschichtung einer negativen lichtempfindlichen Zusammensetzung auf das Substrat, umfassend ein alkalilösliches Harz, ein Vernetzungsmittel für das alkalilösliche Harz, welches unter sauren Bedingungen wirkt, sowie mindestens ein Säure-erzeugendes Photomaterial, das ausgewählt ist aus der Gruppe, bestehend aus einem C₁-C₈-Paraffinkohlenwasserstoff oder C₅-C₇-Cydoparaffinkohlenwasserstoff, der mit mindestens zwei Brom- oder Iodatomen substituiert ist, (2) deren Erhitzen und Trocknen, (3) deren Unterwerfüng einer Belichtung mit Hilfe einer Quecksilberlampe oder eines Excimerlasers, (4) deren Unterwerfüng unter eine Hitzebehandlung und (5) deren Entwicklung mit einer wäßrigen Alkalilösung, um ein Photolackmuster auf dem Substrat zu bilden.

## Revendications

1. Composition photosensible négative comprenant une résine soluble dans un alcalin, un matériau générateur d'acide par voie photochimique et un agent de réticulation pour la résine soluble dans un alcalin, qui agit dans des conditions acides, dans laquelle ledit matériau générateur d'acide par voie photochimique est au moins un élément choisi dans le groupe constitué d'un hydrocarbure paraffinique en C₁ à C₈ et d'un hydrocarbure cycloparaffinique en C₅ à C₇ substitués par au moins deux atomes d'iode ou de brome.

2. Composition photosensible négative selon la revendication 1 dans laquelle le matériau générateur d'acide par voie photochimique est un hydrocarbure paraffinique en C₁ à C₆ ou un hydrocarbure cycloparaffinique en C₅ à C₇, qui est substitué par au moins deux atomes d'iode ou de brome.

3. Composition photosensible négative selon la revendication 1 dans laquelle la résine soluble dans un alcalin est une résine novolaque ou un dérivé du polyvinylphénol.

4. Composition photosensible négative selon la revendication 1 dans laquelle l'agent de réticulation est un composé comportant au moins deux groupes de formule suivante (V) par molécule ou un composé comportant au moins un groupe de formule suivante (VI) par molécule : 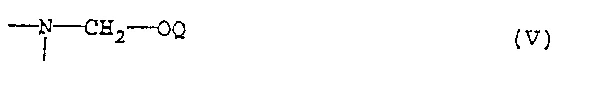
-N(CH₂OQ')₂ (VI)
dans lesquelles chacun de Q et Q', qui sont indépendants l'un de l'autre, est un atome d'hydrogène ou un groupe alkyle en C₁ à C₄.

5. Composition photosensible négative selon la revendication 1 dans laquelle le matériau générateur d'acide par voie photochimique est présent en une quantité allant de 0,05 à 20 parties en poids et l'agent de réticulation est présent en une quantité allant de 1 à 50 parties en poids, pour 100 parties en poids de la résine soluble dans un alcalin.

6. Procédé pour réaliser un motif de résist sur un substrat pour un semi-conducteur, qui comprend les étapes consistant à (1) revêtir le substrat d'une composition photosensible négative comprenant une résine soluble dans un alcalin, un agent de réticulation pour la résine soluble dans un alcalin qui agit dans des conditions acides et au moins un matériau générateur d'acide par voie photochimique choisi dans le groupe constitué d'un hydrocarbure paraffinique en C₁ à C₈ et d'un hydrocarbure cycloparaffinique en C₅ à C₇ substitués par au moins deux atomes d'iode ou de brome, (2) la chauffer et la sécher, (3) la soumettre à une exposition lumineuse au moyen d'une lampe à mercure ou d'un laser excimer, (4) la soumettre à un traitement thermique et (5) la développer à l'aide d'une solution aqueuse alcaline en vue de former un motif de résist sur le substrat.
